# FASCICULE DE BREVET EUROPEEN

(11) **EP 0 571 252 B1**
(45) Date de publication et mention de la délivrance du brevet: **05.08.1998**
(21) Numéro de dépôt: 93401238.6
(22) Date de dépôt: 14.05.1993
(51) Int. Cl.: G01R 31/26, G01R 31/28

(54) **Module porte-échantillon destiné aux tests d'un composant optique**
Probenhaltermodul für Tests eines optischen Bauelementes
Sample holder module for tests of an optical component

(30) Priorité: 22.05.1992 FR 9206282
(43) Date de publication de la demande: 24.11.1993
(73) Titulaire: INGENIERIE ELECTRO-OPTIQUE EXFO INC., Vanier, Quebec G1M 3G7 (CA)
(72) Inventeur: Laine, Bernard, F-94130 Nogent sur Marne (FR)
(74) Mandataire: Keib, Gérard

(56) Documents cités:
- EP-A- 0 047 141
- FR-A- 2 426 984
- PATENT ABSTRACTS OF JAPAN vol. 10, no. 125 (E-402)10 Mai 1986
- PATENT ABSTRACTS OF JAPAN vol. 13, no. 57 (P-825)9 Février 1989
- SOLID STATE TECHNOLOGY vol. 27, no. 2, Février 1984, WASHINGTON US pages 169 - 179 F.F. OETTINGER 'Thermal Evaluation of VLSI Packages Using Test Chips - A Critical Review'

## Description

La présente invention a pour objet un module porte-échantillon destiné au test d'un composant optique.

Les composants optiques, en particulier les diodes laser, sont soumis en fin de fabrication à une série de tests destinés à mesurer et à vérifier leurs performances dans différentes conditions et dans différents environnements. Un des tests couramment pratiqués est le test d'endurance cyclique ou de vieillissement ("burn-in") dans lequel le composant est soumis à des cycles thermiques prédéterminés, par exemple une série de cycles thermiques alternant entre - 40°C et +80°C. Au cours de ce test, on mesure le faisceau de la diode laser en même temps qu'un certain nombre d'éléments caractéristiques de la température ainsi que d'autres paramètres. Dans les techniques actuellement mises en oeuvre dans les bancs de mesure de ce type, le composant optique doit être monté et démonté pour chacun des tests. Les composants, tels que les diodes laser, qui sont fournis avec une certaine longueur de fibre optique sont fragiles. Il est donc hautement souhaitable d'éviter ces opérations répétées de montage et de démontage qui risquent de les détériorer.

Une solution, préconisée par le JP-A-63 247 676 selon les Patent Abstracts of Japan, vol. 13, n°. 57 (P-825), consiste à prévoir un banc multi-tests apte à recevoir un support enfichable portant le composant optique. Les mesures de température sont effectuées à l'aide d'une première plaque de circuit imprimé à laquelle est connecté le composant optique, cette première plaque étant insérée dans le support enfichable, ainsi qu'à l'aide d'autres circuits imprimés prévus sur le banc de tests. Le système présente toutefois certaines limitations d'utilisation: en particulier, le banc multi-tests est nécessairement prévu pour un nombre fini de mesures. D'autre part, le support enfichable, de structure extrêmement simple, est adapté à un type de composant optique donné.

La présente invention a pour objet un module porte-échantillon permettant de réaliser un test de vieillissement d'un composant optique tel qu'une diode laser, ainsi qu'un nombre non limité d'autres tests, sans montage et démontage successifs du composant à mesurer.

Le module porte-échantillon selon l'invention comporte une première plaque de circuit imprimé comportant :
- une première région dans laquelle est disposée une deuxième plaque de circuit imprimé comportant des éléments de contact électrique agencés d'une part pour réaliser une connexion électrique avec des pattes de connexion dudit composant optique et d'autre part, pour solidariser mécaniquement le composant optique au deuxième circuit imprimé par lesdites pattes de connexion, une plaque thermiquement conductrice bloquée entre la première et la deuxième plaques de circuit imprimé de manière à pouvoir venir en contact mécanique avec une surface dissipatrice thermique du composant optique, la plaque thermiquement conductrice étant disposée face à une ouverture du premier circuit imprimé, et un couvercle solidaire du deuxième circuit imprimé, disposé sur une ouverture de ce dernier et adapté à entourer substantiellement le composant optique, du côté opposé à la plaque thermiquement conductrice ;
- une deuxième région dans laquelle est disposé un élément de mesure d'une caractéristique optique du composant optique.

Le couvercle est avantageusement thermiquement isolant et porte une sonde thermique destinée à venir en contact avec une face du composant optique opposée à ladite surface dissipatrice thermique.

Les pattes de connexion du composant optique pourront être pincées entre le couvercle et ladite deuxième plaque de circuit imprimé.

La plaque thermo-conductrice peut être pincée sur une majeure partie de son contour externe entre deux entretoises solidaires des premier et deuxième circuits imprimés.

La deuxième région peut comporter un logement pour recevoir une longueur de fibre optique du composant optique.

La deuxième région peut comporter un moyen de fixation pour maintenir en position une férule dans laquelle est introduite une extrémité de la fibre optique. En variante, la fibre optique peut comporter un connecteur d'extrémité destiné à être maintenu en place dans la deuxième région.

Le premier et le deuxième circuits imprimés peuvent comporter respectivement un premier et un deuxième moyens de connexion. La deuxième région de circuit imprimé peut alors comporter au moins une ouverture à travers laquelle passe au moins un câble de connexion dont une extrémité est connectée à l'un au moins des premier et deuxième circuits imprimés. D'autres caractéristiques et avantages de l'invention apparaîtront mieux à la lecture de la description qui va suivre, donnée à titre d'exemple non limitatif, en liaison avec les dessins qui représentent :
- la figure 1A, une vue en plan d'un module porte-échantillon selon l'invention,
- la figure 1B, une coupe selon A-A de la figure 1A,
- les figures 2 et 3, deux variantes de montage des extrémités de la fibre optique dans le module selon l'invention.

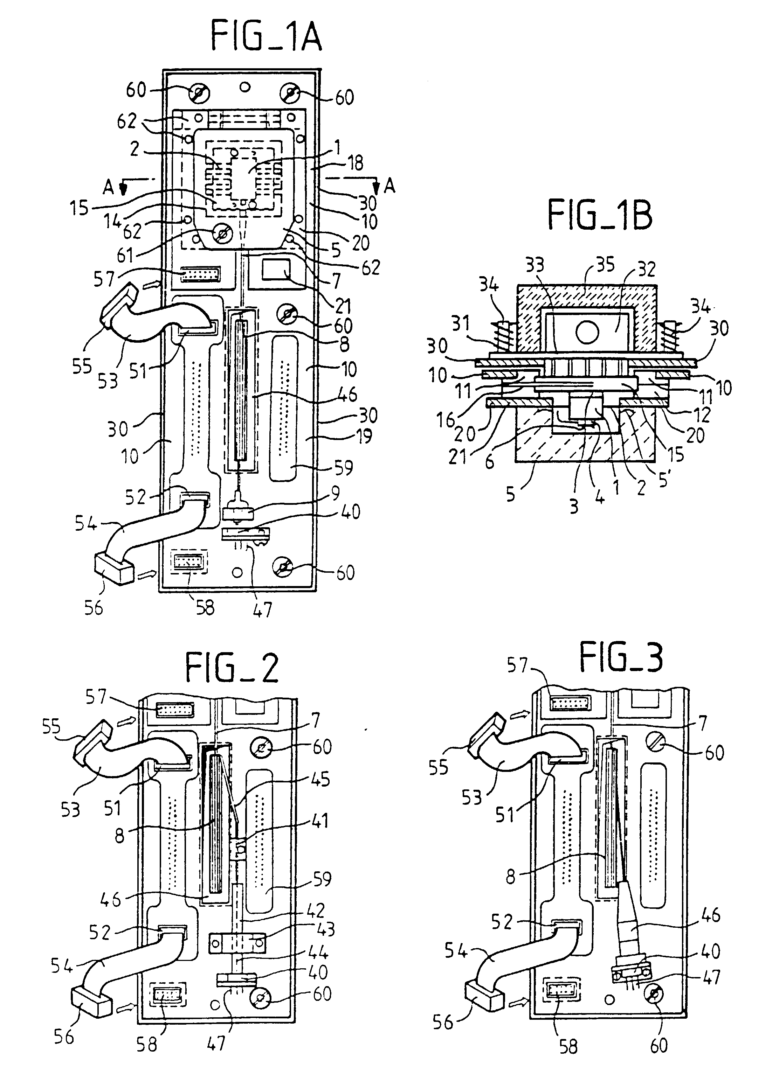

Selon les figures 1A et 1B, un module comporte d'une part une première région 18 dans laquelle est logé un composant optique 1 à tester, le bras optique 1, par exemple une diode laser présente des pattes conductrices de sortie 2 qui sont prises en sandwich entre une plaquette de circuit imprimé 20 et un couvercle 5 vissé sur celui-ci par une vis quart-de-tour 61. La plaquette de circuit imprimé 20 est fixée par des vis 62 qui assurent la solidarité mécanique du circuit imprimé 20, de deux entretoises 11 et 12 et du circuit imprimé 10. Les entretoises 11 et 12 maintiennent en place par pincement une plaque thermiquement conductrice 15 qui est en contact mécanique avec une face dissipatrice de la chaleur 3 du composant 1. Le couvercle 5 présente une sonde de température 6 qui est en contact avec la face 4 du composant opposée à la face de dissipation thermique 3. Le boîtier 5 est en matériau thermiquement isolant, la sonde de température 6 permet à chaque instant d'évaluer la température du composant optique 1 tel qu'une diode laser.

On remarquera que le circuit imprimé 20 comporte, en dehors de la zone de couvercle 5, un connecteur 57 et un relais à mercure 21.

Le circuit imprimé 10 comporte, dans sa région 19, un logement 46 destiné à recevoir des spires 8 de fibre optique 7, cette fibre présentant à son extrémité une férule 9 disposée avec précision par rapport à un capteur de mesure 40 d'un type couramment utilisé dans les bancs de mesures de composants optiques. La partie 19 du circuit imprimé 10 comporte également deux ouvertures 51 et 52 destinées à laisser passer des câbles, respectivement 53 et 54, portant à une extrémité des connecteurs, respectivement 55 et 56, destinés à coopérer respectivement avec le connecteur 57 du circuit imprimé 20 et un connecteur 58 implanté à la partie inférieure du circuit imprimé 10. Une ouverture 59 dans la région 19 du circuit imprimé 10 permet le passage d'un connecteur pour un circuit imprimé de base 30 solidaire de l'installation de test. Le circuit imprimé 10 présente quatre vis quart-de-tour 60 destinées à permettre son montage sur un circuit imprimé de base 30 constituant un poste d'un banc de mesure et qui porte des connecteurs (non représentés) coopérant avec des connecteurs situés aux autres extrémités des câbles 53 et 54. Pour le test de vieillissement comprenant des cycles thermiques, par exemple entre -40 et +80°, le circuit imprimé 30 présente, de manière connue, un élément à effet Peltier 31, collé sur un radiateur 33 solidaire d'un carter 35 à l'intérieur duquel circule un liquide de chauffage ou de refroidissement 32 à savoir de l'eau de ville ou bien de l'eau refroidie glycolée pour des tests impliquant des températures négatives (< 0°C). Le radiateur 33 est monté sur ressorts 34 pour permettre à l'élément Peltier 31 d'être bien appliqué contre la plaque conductrice 15.

L'effet Peltier 31 traverse une ouverture 14 du circuit imprimé 10 et s'étend au-delà de la surface de l'entretoise 11 pour venir en contact mécanique et thermique avec la plaque conductrice de la chaleur 15 dans laquelle est disposée une sonde de mesure de température 16.

Il résulte de la structure décrite ci-dessus les caractéristiques suivantes.

Le couvercle 5, par exemple monté sur charnière, est pourvu de doigts presseurs électriquement conducteurs 5' et d'une sonde de température 6 montée sur ressort assure une triple fonction, à savoir une pression individuelle sur chaque des pattes du module pour maintenir un bon contact électrique, un plaquage de la sonde de température 6 sur la face externe supérieure 4 du module pour mesurer sa température, et enfin l'isolation thermique du module. La plaque thermiquement conductrice 15 est isolée thermiquement et mécaniquement des circuits imprimés 10 et 20 par les deux entretoises 11 et 12 constituées par des plaques en matériau isolant électrique et thermique. Selon la figure 2, la dernière spire 45 de l'enroulement de spires 8 est maintenue en place en 41, l'extrémité 44 de la fibre, précédemment introduite dans un tube 42 en verre fabriqué avec précision, est bloquée en position de manière connue en soi, par une bride 43 de telle sorte que la fibre optique ait son axe optique positionné avec précision par rapport à la sonde de mesure 40. Selon la variante de la figure 3, l'extrémité de la fibre optique comporte un connecteur prémonté 46 qui coopère avec la sonde de mesure 40.

Le module tel que décrit ci-dessus peut être démonté à l'aide des vis quart-de-tour 60 et utilisé sur d'autres bancs de tests, que ceux-ci présentent ou non des éléments de chauffage ou de refroidissement tels que les éléments Peltier 31.

## Revendications

1. Module porte-échantillon destiné au test d'un composant optique, comportant une première plaque de circuit imprimé (10) comportant :
- une première région (18) dans laquelle est disposée une deuxième plaque de circuit imprimé (20) comportant des éléments de contact électrique (21) agencés d'une part pour réaliser une connexion électrique avec des pattes de connexion (2) dudit composant optique (1) et d'autre part, pour solidariser mécaniquement le composant optique (1) au deuxième circuit imprimé par lesdites pattes de connexion (2), une plaque thermiquement conductrice (15) bloquée entre la première (10) et la deuxième (20) plaques de circuit imprimé de manière à pouvoir venir en contact mécanique avec une surface dissipatrice thermique (3) du composant optique (1), la plaque thermiquement conductrice (15) étant disposée face à une ouverture (14) du premier circuit imprimé (10), et un couvercle (5) solidaire du deuxième circuit imprimé (20), disposé sur une ouverture de ce dernier et adapté à entourer substantiellement le composant optique (1), du côté opposé à la plaque thermiquement conductrice (15) ;
- une deuxième région (19) dans laquelle est disposé un élément de mesure (40) d'une caractéristique optique du composant optique (1).

2. Module porte-échantillon selon la revendication 1, caractérisé en ce que ledit couvercle (5) est thermiquement isolant et porte une sonde thermique (6) destinée à venir en contact avec une face (4) du composant optique (1) opposée à ladite surface dissipatrice thermique (3).

3. Module porte-échantillon selon la revendication 1, caractérisé en ce qu'il autorise la solidarisation du composant optique (1) à la deuxième plaque de circuit imprimé (20), par pincement des pattes de connexion (2) du composant optique (1) entre ledit couvercle (5) et ladite deuxième plaque de circuit imprimé (20).

4. Module porte-échantillon selon la revendication 1, caractérisé en ce que la plaque thermo-conductrice (15) est pincée sur une majeure partie de son contour externe entre deux entretoises (11, 12) solidaires des premier (10) et deuxième (20) circuits imprimés.

5. Module porte-échantillon selon la revendication 1, caractérisé en ce que la deuxième région (19) comporte un logement (46) pour recevoir une longueur (8) de fibre optique (7) du composant optique (1).

6. Module porte-échantillon selon la revendication 5, caractérisé en ce que la deuxième région (19) comporte un moyen de fixation (43) maintenant en position un tube (42) apte à recevoir une extrémité (44) de ladite fibre optique (7).

7. Module porte-échantillon selon la revendication 5, caractérisé en ce que la deuxième région (19) est adaptée pour le maintien en place d'un connecteur d'extrémité (46) porté par la fibre optique (7).

8. Module porte-échantillon selon la revendication 1, caractérisé en ce que le premier circuit imprimé (10) comporte un premier moyen de connexion (58) et en ce que le deuxième circuit imprimé comporte un deuxième moyen de connexion (57).

9. Module porte-échantillon selon la revendication 8, caractérisé en ce que la deuxième région (19) du premier circuit imprimé (10) comporte au moins une ouverture (51, 52) à travers laquelle passe au moins un câble de connexion (53, 54) dont une extrémité (55, 56) est connectée à l'un au moins des moyens de connexion (57, 58) des premier (10) et deuxième (20) circuits imprimés.

## Patentansprüche

1. Probenhaltermodul für Tests eines optischen Bauteils mit einer ersten gedruckten Schaltung (10), die aufweist:
- einen ersten Bereich (18), in dem eine zweite gedruckte Schaltung (20) mit elektrischen Kontaktelementen (20) angeordnet ist, die einerseits zur Ausführung eines elektrischen Anschlusses an Anschlußklemmen (2) des optischen Bauteils (1) und andererseits zur mechanischen einstückigen Ausbildung des optischen Bauteils mit der zweiten gedruckten Schaltung durch die Anschlußklemmen (2) angeordnet sind, wobei eine Wärmeleitplatte (15) zwischen der ersten und der zweiten gedruckten Schaltung derart blockiert ist, daß sie mit einer Kühlfläche (3) des optischen Bauteils (1) in mechanischen Kontakt kommen kann, wobei die Wärmeleitplatte (15) gegenüber einer Öffnung (14) der ersten gedruckten Schaltung (19) angeordnet ist und eine mit der zweiten gedruckten Schaltung (20) einstückig ausgebildte Abdeckung (5) auf einer Öffnung dieser letzteren angeordnet und dafür eingerichtet ist, im wesentlichen das optische Bauteil (1) auf der der Wärmeleitplatte (15) gegenüberliegenden Seite zu umgeben;
- einen zweiten Bereich (19), in dem ein Meßelement (40) für eine optische Eigenschaft des optischen Bauteils (1) angeordnet ist.

2. Probenhaltermodul gemäß Anspruch 1, dadurch gekennzeichnet, daß die Abdeckung (5) wärmeisolierend ist und eine Wärmesonde (6) trägt, die dazu bestimmt ist, mit einer der Kühlfläche (3) gegenüberliegenden Seite (4) des optischen Bauteils (1) in Kontakt zu kommen.

3. Probenhaltermodul gemäß Anspruch 1, dadurch gekennzeichnet, daß es die einstückige Ausbildung des optischen Bauteils (1) mit der zweiten gedruckten Schaltung (20) durch Einklemmen der Anschlußklemmen (2) des optischen Bauteils (1) zwischen der Abdeckung (5) und der zweiten gedruckten Schaltung (20) ermöglicht.

4. Probenhaltermodul gemäß Anspruch 1, dadurch gekennzeichnet, daß die Wärmeleitplatte (15) auf einem größeren Teil ihres äußeren Umrisses zwischen zwei mit der ersten (10) und zweiten (20) gedruckten Schaltung einstückig ausgebildeten Streben (11, 12) festgeklemmt ist.

5. Probenhaltermodul gemäß Anspruch 1, dadurch gekennzeichnet, daß der zweite Bereich (19) eine Aufnahme (46) zum Aufnehmen einer optischen Faser (7)-Länge (8) des optischen Bauteils (1) aufweist.

6. Probenhaltermodul gemäß Anspruch 5, dadurch gekennzeichnet, daß der zweite Bereich (19) eine Befestigungsvorrichtung (43) aufweist, die ein Rohr (42) in Position hält, das dafür eingerichtet ist, ein Ende (44) der optischen Faser (7) aufzunehmen.

7. Probenhaltermodul gemäß Anspruch 5, dadurch gekennzeichnet, daß der zweite Bereich (19) dafür eingerichtet ist, ein von der optischen Faser (7) getragenes Endverbindungsstück (46) an seinem Platz zu halten.

8. Probenhaltermodul gemäß Anspruch 1, dadurch gekennzeichnet, daß eine erste gedruckte Schaltung (10) eine erste Anschlußvorrichtung (58) aufweist und daß die zweite gedruckte Schaltung eine zweite Anschlußvorrichtung (57) aufweist.

9. Probenhaltermodul gemäß Anspruch 8, dadurch gekennzeichnet, daß der zweite Bereich (19) der ersten gedruckten Schaltung (10) zumindest eine Öffnung (51, 52) aufweist, durch die zumindest ein Anschlußkabel (53, 54) läuft, dessen eines Ende (55, 56) an zumindest eine der Anschlußvorrichtungen (57, 58) der ersten (10) und zweiten (20) gedruckten Schaltung angeschlossen ist.

## Claims

1. Sample-holder module intended for the testing of an optical component, which includes a first printed-circuit board (10) having:
- a first region (18) in which is placed a second printed-circuit board (20) having electrical contact elements (21) which are designed, on the one hand, to make electrical connection to connection pads (2) on the said optical component (1) and, on the other hand, to mechanically fasten the optical component (1) to the second printed circuit via the said connection pads (2), a thermally conductive plate (15) which is jammed between the first printed-circuit board (10) and the second printed-circuit board (20) so as to be able to come into mechanical cnntact with a heat-dissipating surface (3) of the optical component (1), the thermally conductive plate (15) being placed facing an opening (14) in the first printed circuit (10), and a lid (5) fastened to the second printed circuit (20), placed over an opening in the latter and suitable for substantially surrounding the optical component (1), on the side opposite the thermally conductive plate (15);
- a second region (19) in which is placed an element (40) for measuring an optical property of the optical component (1).

2. Sample-holder module according to Claim 1, characterized in that the said lid (5) is thermally insulating and bears a thermal probe (6) intended to come into contact with one face (4) of the optical component (1), this face being opposite the said heat-dissipating surface (3) .

3. Sample-holder module according to Claim 1, characterized in that it allows the optical component (1) to be fastened to the second printed-circuit board (20) by clamping the connection pads (2) of the optical component (1) between the said lid (5) and to the said second printed-circuit board (20).

4. Sample-holder module according to Claim 1, characterized in that the thermally conductive plate (15) is clamped over a major part of its external contour between two spacers (11, 12) which are fastened to the first printed circuit (10) and to the second printed circuit (20).

5. Sample-holder module according to Claim 1, characterized in that the second region (19) includes a housing (46) for accommodating a length (8) of optical fibre (7) of the optical component (1).

6. Sample-holder module according to Claim 5, characterized in that the second region (19) includes a fixing means (43) which holds a tube (42), capable of receiving one end (44) of the said optical fibre (7), in position.

7. Sample-holder module according to Claim 5, characterized in that the second region (19) is suitable for holding an end connector (46), which is borne by the optical fibre (7), in place.

8. Sample-holder module according to Claim 1, characterized in that the first printed circuit (10) includes a first connection means (58) and in that the second printed circuit includes a second connection means (57).

9. Sample-holder module according to Claim 8, characterized in that the second region (19) of the first printed circuit (10) has at least one opening (51, 52) through which at least one connection cable (53, 54) passes, one end (55, 56) of which connection cable is connected to at least one of the connection means (57, 58) of the first printed circuit (10) and of the second printed circuit (20).
